# EUROPEAN PATENT APPLICATION

(11) **EP 4 462 616 A1**
(43) Date of publication of application: **13.11.2024**
(21) Application number: 24162483.2
(22) Date of filing: 08.03.2024
(51) Int. Cl.: H01S 3/063, H01S 3/083, H01S 3/30, H01S 3/094, H01S 3/0941

(54) **STIMULATED BRILLOUIN SCATTERING LASER WITH REDUCED FUNDAMENTAL LINEWIDTH AND FREQUENCY PULLING**

(30) Priority: 09.05.2023 US 202318314657
(71) Applicant: Honeywell International Inc., Charlotte, NC 28202 (US)
(72) Inventor: PUCKETT, Matthew Wade, Charlotte, 28202 (US); WU, Jianfeng, Charlotte, 28202 (US); QIU, Tiequn, Charlotte, 28202 (US); TIN, Steven, Charlotte, 28202 (US); NELSON, Karl D., Charlotte, 28202 (US); HOYT, Chad, Charlotte, 28202 (US)
(74) Representative: Haseltine Lake Kempner LLP

(57) **Abstract**

A photonics device comprises a waveguide platform including a substrate layer, a cladding layer over the substrate layer, and a waveguide layer embedded in the cladding layer. The waveguide layer includes a waveguide ring resonator, and a bus waveguide in optical communication with the waveguide ring resonator. The waveguide ring resonator is configured to generate a stimulated Brillouin scattering (SBS) beam when a pump laser beam is optically coupled into the waveguide ring resonator from the bus waveguide. The waveguide ring resonator has a radius and corresponding round-trip path length such that a free-spectral range (FSR) of the waveguide ring resonator is misaligned with respect to a SBS gain peak of the SBS beam, such that an SBS gain coefficient has a magnitude to produce a substantially reduced linewidth of the SBS beam.

## Description

This invention was made with Government support under HR0011-22-C-0018 awarded by DARPA. The Government has certain rights in the invention.

### BACKGROUND

Stimulated Brillouin scattering (SBS) lasers are a valuable class of technology, producing light with extremely narrow linewidths. In the state-of-the-art, SBS lasers are made in integrated photonics platforms by designing optical resonators in which the free-spectral range (FSR) matches the frequency shift corresponding to Brillouin scattering. However, this places the SBS lasers in a high gain regime of operation, which sets a lower limit on the minimum linewidth that can be obtained by the generated laser light due to a high rate of spontaneous light emission, driven by thermal phonon distribution.

### SUMMARY

A photonics device comprises a waveguide platform including a substrate layer, a cladding layer over the substrate layer, and a waveguide layer embedded in the cladding layer. The waveguide layer includes a waveguide ring resonator, and a bus waveguide in optical communication with the waveguide ring resonator. The waveguide ring resonator is configured to generate a stimulated Brillouin scattering (SBS) beam when a pump laser beam is optically coupled into the waveguide ring resonator from the bus waveguide. The waveguide ring resonator has a radius and corresponding round-trip path length such that a free-spectral range (FSR) of the waveguide ring resonator is misaligned with respect to a SBS gain peak of the SBS beam, such that an SBS gain coefficient has a magnitude to produce a substantially reduced linewidth of the SBS beam.

### BRIEF DESCRIPTION OF THE DRAWINGS

Features of the present invention will become apparent to those skilled in the art from the following description with reference to the drawings. Understanding that the drawings depict only typical embodiments and are not therefore to be considered limiting in scope, the invention will be described with additional specificity and detail through the use of the accompanying drawings, in which:
Figure 1A is a schematic diagram of an optical resonator device for a conventional stimulated Brillouin scattering (SBS) laser;
Figure 1B is a graph representing the operation of the optical resonator device of Figure 1A;
Figure 2A is a schematic diagram of an optical resonator device for an SBS laser, according to the present approach;
Figure 2B is a graph representing the operation of the optical resonator device of Figure 2A;
Figure 3 is a perspective view of a photonics device for a conventional SBS laser including a waveguide platform;
Figure 4 is a perspective view of a photonics device for an SBS laser, according to an exemplary embodiment of the present approach; and
Figure 5 is a schematic illustration of an SBS laser system, according to one embodiment, which can be implemented according to the present approach.

### DETAILED DESCRIPTION

In the following detailed description, embodiments are described in sufficient detail to enable those skilled in the art to practice the invention. It is to be understood that other embodiments may be utilized without departing from the scope of the invention. The following detailed description is, therefore, not to be taken in a limiting sense.

A stimulated Brillouin scattering (SBS) laser system, with reduced fundamental linewidth and frequency pulling, is described herein.

In the present approach, a free-spectral range (FSR) of an optical resonator used to produce an SBS laser is deliberately misaligned from a peak of the SBS gain curve by altering the resonator length. This misalignment reduces the SBS gain coefficient present in the SBS laser, which has two effects. First, the misalignment increases a lasing threshold, which can be detrimental to performance if the loss coefficient of the resonator is not sufficiently low. However, if the loss coefficient is sufficiently low, reducing the SBS gain coefficient also has the effect of reducing the laser linewidth when the SBS laser is driven above a certain threshold, such as about 10 mW of optical pump power.

In various embodiments, a waveguide ring resonator on a waveguide platform of a photonics device can be formed with a radius of a given size such that the FSR of the ring resonator is reduced, thereby moving the photonics device into a lower gain regime, and thereby reducing an SBS laser linewidth.

Alternatively, while the gain can be reduced if the FSR of the ring resonator is increased, it would be harder to target a specific gain coefficient because of the structure of the gain curve.

An additional benefit that comes from operating in the low gain regime is that gain (frequency) pulling, a nonideality which changes the wavelength of emission of the laser, is significantly reduced. This is because the gain curve is flatter with respect to changing frequencies at frequencies farther from the gain peak, and gain pulling is proportional to the local derivative of the gain.

In order to make the present SBS lasers, an optical resonator can be fabricated in a waveguide platform that possesses a sufficiently large SBS gain coefficient, such as about 0.05 (Wm)⁻¹, and sufficiently low loss, such as about 0.1 dB/m. In the design of the resonator, a round-trip path length is controlled such that a multiple of the FSR is close to, but not equal to, the frequency shift corresponding to peak SBS gain. For example, the lasing resonance could be detuned from the gain peak by about 400 MHz to reduce the gain coefficient by at least one order of magnitude.

During operation of the present SBS laser, optical pump power is injected into a bus waveguide of the resonator, with the pump power either scanned through an optical resonance or locked to a resonance of the resonator. When the optical pump is at sufficiently high optical power, the resonator will produce narrow linewidth laser light through SBS.

Further details regarding the present approach are described as follows and with reference to the drawings.

As described previously, conventional SBS lasers are made on integrated photonics platforms by designing optical resonators in which the FSR matches a frequency shift corresponding to Brillouin scattering.

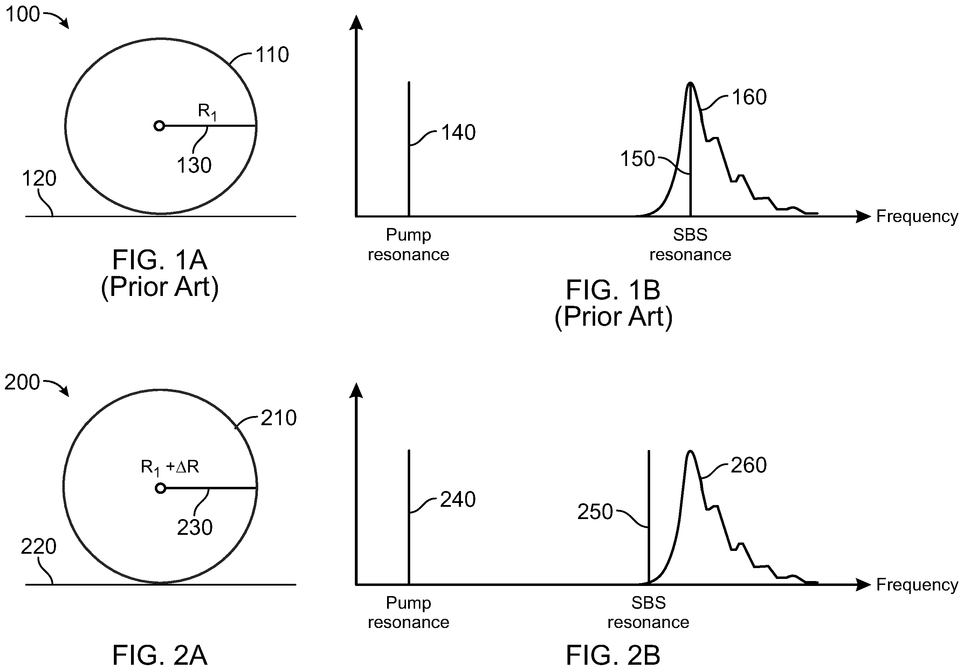

For example, Figure 1A is a schematic diagram of an optical resonator device 100 for a conventional SBS laser. The optical resonator device 100 includes a ring resonator 110 and a bus waveguide 120 in optical communication with ring resonator 110. The ring resonator 110 has a radius 130 (Ri) such that a length (i.e., circumference) of ring resonator 110 provides a FSR that is aligned to an SBS gain.

Figure 1B is a graph illustrating the operation of optical resonator device 100. A pump resonance 140 is at a given lower frequency, and an SBS resonance 150 is at a higher frequency that is aligned with a FSR peak 160 of ring resonator 110.

In the present SBS laser, a ring resonator has an increased radius such that the FSR of the ring resonator is in misalignment with the SBS gain, thereby moving the SBS laser into a low gain regime to provide a reduced linewidth of the SBS output beam.

For example, Figure 2A is a schematic diagram of an optical resonator device 200 for an SBS laser, according to the present approach. The optical resonator device 200 includes a waveguide ring resonator 210 and a bus waveguide 220 in optical communication with ring resonator 210. The ring resonator 210 has an increased radius 230 (R₁ + ΔR), with respect to the first radius 130 (Ri) of ring resonator 110 (Fig. 1A) The increased radius 230 of ring resonator 210 provides an increased length (i.e., circumference) of ring resonator 210 such that its FSR is in misalignment with the SBS gain, thereby moving the SBS laser into a lower gain regime to provide a reduced linewidth of the SBS output beam.

Figure 2B is a graph illustrating the operation of an SBS laser with optical resonator device 200. A pump resonance 240 is at a given lower frequency, and an SBS resonance 250 is at a higher frequency, but misaligned with a FSR peak 260 of ring resonator 210 such that the SBS laser has a lower gain. This provides a reduced linewidth of the SBS output beam, compared to the linewidth of the SBS output beam from an SBS laser with optical resonator device 100.

A waveguide ring resonator used in the present SBS laser can be formed on a waveguide platform of a photonics chip. The waveguide platform can be produced by fabricating a photonics waveguide such as by using one of several well-established integrated photonics fabrication processes known to those skilled in the art. In fabricating the waveguide platform, a substrate is provided, such as an initial wafer, which can also include an underlying handle wafer. A cladding material is then deposited on the substrate to form a cladding layer, such as by a conventional deposition process. Thereafter, a waveguide material is deposited on the cladding layer to form a waveguide layer, such as by a conventional deposition process. The waveguide ring resonator and an associated waveguide bus are formed in the waveguide layer using standard microfabrication techniques, such as lithography, etching, and resist removal processes.

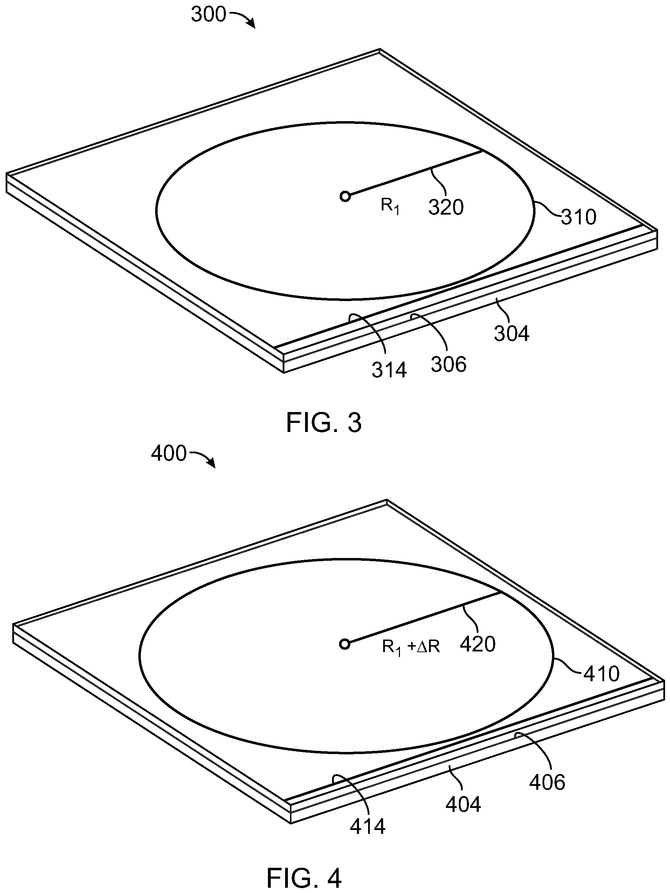

Figure 3 is a perspective view of a photonics device 300 for a conventional SBS laser. The photonics device 300 includes a waveguide platform comprising a substrate layer 304, and a cladding layer 306 over substrate layer 304. A waveguide layer is embedded in cladding layer 306 and includes a ring resonator 310, and a bus waveguide 314 in optical communication with ring resonator 310. The ring resonator 310 has a radius 320 (Ri) such that a length of ring resonator 310 provides a FSR that is aligned to an SBS gain.

In contrast, Figure 4 is a perspective view of a photonics device 400 for an SBS laser, according to an exemplary embodiment of the present approach. The photonics device 400 includes a waveguide platform comprising a substrate layer 404, and a cladding layer 406 over substrate layer 404. A waveguide layer is embedded in cladding layer 406 and includes a ring resonator 410 and a bus waveguide 414 in optical communication with ring resonator 410. In an example embodiment, substrate layer 404 can be composed of silicon, and cladding layer 406 can be composed of silicon dioxide. The waveguide layer including ring resonator 410 and bus waveguide 414 can be composed of silicon nitride. The waveguide platform can be formed on a photonics chip, such as a silicon photonics integrated circuit.

As shown in Figure 4, ring resonator 410 has an increased radius 420 (R₁ + ΔR), with respect to the radius 320 (Ri) of ring resonator 310 (Fig. 3). The increased radius 420 of ring resonator 410 provides an increased length of ring resonator 410 such that its FSR is in misalignment with respect to the SBS gain, thereby moving the SBS laser into a lower gain regime to provide a reduced linewidth of the SBS output beam.

For example, in SBS lasers that are formed based on low confinement silicon nitride waveguides according the present approach, the laser linewidth can be reduced from about 700 mHz to about 10 mHz, a reduction by about 20 dB.

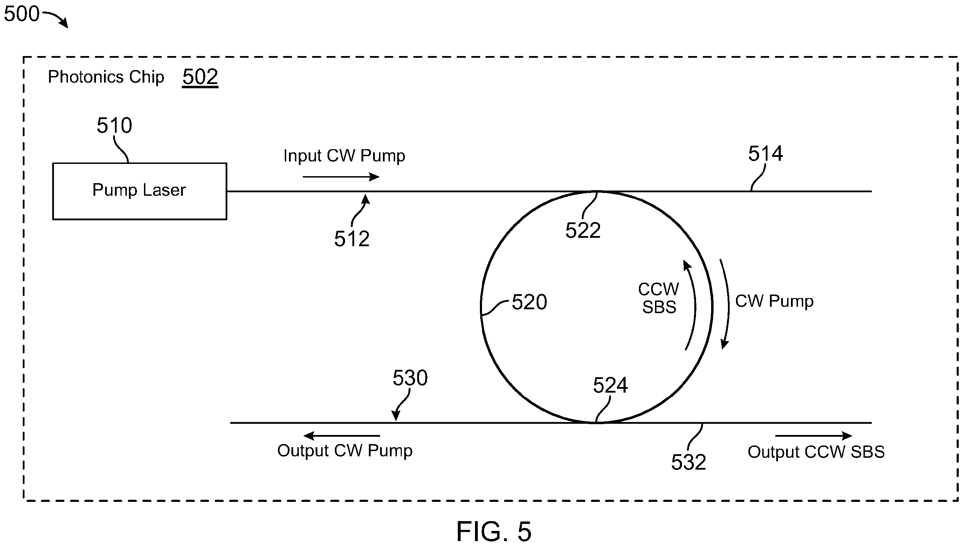

Figure 5 is a schematic illustration of an SBS laser system 500, according to one embodiment, which can be implemented according to the present approach. The SBS laser system 500 generally includes a pump laser device 510, and an optical waveguide resonator 520 in optical communication with pump laser device 510 through an optical waveguide pathway. Each of the components of SBS laser system 500 can be integrated on a photonics chip 502 using standard microfabrication processes.

As shown in Figure 5, pump laser device 510 operative to emit an input pump light beam along a first optical pathway 512. The input pump light beam can be an input clockwise (CW) pump beam, for example. The first optical pathway 512 can include a first bus waveguide 514 optically coupled to an output of pump laser device 510. The pump laser device 510 can be any laser source capable of providing laser light at a desired frequency. For example, pump laser device 510 can a distributed Bragg reflector (DBR) laser, an external cavity diode laser (ECDL), or the like.

The optical waveguide resonator 520, which can be a waveguide ring resonator, is in optical communication with pump laser device 510 through first optical pathway 512. For example, bus waveguide 514 can be optically coupled to optical waveguide resonator 520 at a first optical coupler region 522 on a first side of optical waveguide resonator 520. The optical waveguide resonator 520 is also in optical communication with a second optical pathway 530, which can include a second bus waveguide 532 optically coupled to optical waveguide resonator 520 at a second optical coupler region 524 on a second side of optical waveguide resonator 520.

The optical waveguide resonator 520 can be formed on a waveguide platform on photonics chip 502, such as described previously. The optical waveguide resonator 520 is formed to have a radius size such that its FSR of is in misalignment with an SBS gain. This misalignment with the SBS gain allows SBS laser system 500 to have a lower gain regime, which produces a reduced linewidth of an SBS output beam. For example, the linewidth can be from about 1 Hz to about 10 mHz.

During operation, pump laser device 510 emits the input pump light beam (input CW pump), which is directed into bus waveguide 514. The optical waveguide resonator 520 is configured to receive a portion of the pump light beam from bus waveguide 514 at optical coupler region 522, such that the portion of the pump light beam travels in a first direction in optical waveguide resonator 520, such as in a CW direction as a CW pump beam.

When a frequency of the CW pump beam matches a resonance frequency of optical waveguide resonator 520, an optical power density within optical waveguide resonator 520 increases such that beyond a certain threshold power (e.g., 10 mW), the CW pump beam produces lasing of a first order Brillouin wave (SBS wave), having an SBS gain peak. The SBS wave travels in an opposite second direction in optical waveguide resonator 520, such as in a counterclockwise (CCW) direction as a CCW SBS beam.

A portion of the CW pump beam is coupled out of optical waveguide resonator 520 at optical coupler region 524 into optical pathway 530 along a first direction. For example, the portion of the CW pump beam can be coupled out of optical waveguide resonator 520 into bus waveguide 532 along the first direction as an output CW pump beam. In addition, a portion of the CCW SBS beam is coupled out of optical waveguide resonator 520 at optical coupler region 524 into optical pathway 530 along a second direction. For example, the portion of the CCW SBS beam can be coupled out of optical waveguide resonator 520 into bus waveguide 532 along the second direction as an output CCW SBS beam.

### Example Embodiments

Example 1 includes a photonics device, comprising: a waveguide platform comprising: a substrate layer; a cladding layer over the substrate layer; and a waveguide layer embedded in the cladding layer, the waveguide layer including a waveguide ring resonator, and a bus waveguide in optical communication with the waveguide ring resonator; wherein the waveguide ring resonator is configured to generate a stimulated Brillouin scattering (SBS) beam when a pump laser beam is optically coupled into the waveguide ring resonator from the bus waveguide; wherein the waveguide ring resonator has a radius and corresponding round-trip path length such that a free-spectral range (FSR) of the waveguide ring resonator is misaligned with respect to a SBS gain peak of the SBS beam, such that an SBS gain coefficient has a magnitude to produce a substantially reduced linewidth of the SBS beam.

Example 2 includes the photonics device of Example 1, wherein the linewidth of the SBS beam is about 1 Hz to about 10 mHz.

Example 3 includes the photonics device of any of Examples 1-2, wherein the waveguide platform is coupled to a photonics chip.

Example 4 includes the photonics device of Example 3, wherein the photonics chip comprises a silicon photonics integrated circuit.

Example 5 includes the photonics device of any of Examples 1-4, wherein the substrate layer comprises silicon, the cladding layer comprises silicon dioxide, and the waveguide layer comprises silicon nitride.

Example 6 includes a stimulated Brillouin scattering (SBS) laser system, comprising: a photonics chip; a pump laser device on the photonics chip, the pump laser device operative to emit a pump light beam; an optical waveguide pathway on the photonics chip, the optical waveguide pathway in optical communication with the pump laser device; and an optical waveguide resonator on the photonics chip, the optical waveguide resonator in optical communication with the pump laser device through the optical waveguide pathway; wherein the optical waveguide resonator is configured to receive a portion of the pump light beam such that the portion of the pump light beam travels in a first direction in the optical waveguide resonator; wherein when an optical frequency of the portion of the pump light beam matches a resonance frequency of the optical waveguide resonator, an optical power density within the optical waveguide resonator increases such that beyond a certain threshold power, the portion of the pump light beam produces lasing of a first order Brillouin wave including a SBS wave having a SBS gain peak, wherein the SBS wave travels in an opposite second direction in the optical waveguide resonator; wherein the optical waveguide resonator has a radius and corresponding round-trip path length such that a free-spectral range (FSR) of the optical waveguide resonator is misaligned with respect to the SBS gain peak, such that an SBS gain coefficient has a magnitude to produce a substantially reduced linewidth of the SBS wave.

Example 7 includes the SBS laser system of Example 6, further comprising: an SBS output in optical communication with the optical waveguide resonator; wherein the SBS output is configured to receive the SBS wave from the optical waveguide resonator.

Example 8 includes the SBS laser system of any of Examples 6-7, wherein the linewidth of the SBS beam is about 1 Hz to about 10 mHz.

Example 9 includes the SBS laser system of any of Examples 6-8, wherein the photonics chip comprises a silicon photonics integrated circuit.

Example 10 includes the SBS laser system of any of Examples 6-9, wherein the pump laser device comprises a distributed Bragg reflector (DBR) laser, or an external cavity diode laser (ECDL).

Example 11 includes the SBS laser system of any of Examples 6-10, wherein the optical waveguide resonator comprises a waveguide ring resonator.

Example 12 includes the SBS laser system of any of Examples 6-11, wherein the optical waveguide pathway includes a first optical pathway comprising a first bus waveguide optically coupled to an output of the pump laser device.

Example 13 includes the SBS laser system of Example 12, wherein the first bus waveguide is optically coupled to the waveguide ring resonator at a first optical coupler region on a first side of the waveguide ring resonator.

Example 14 includes the SBS laser system of Example 13, wherein the optical waveguide pathway includes a second optical pathway comprising a second bus waveguide optically coupled to the waveguide ring resonator at a second optical coupler region on a second side of the waveguide ring resonator.

Example 15 includes the SBS laser system of Example 14, wherein: the waveguide ring resonator is configured to receive the portion of the pump light beam from the first bus waveguide at the first optical coupler region, such that the portion of the pump light beam travels in the first direction in the waveguide ring resonator as a clockwise (CW) pump beam; and the SBS wave travels in the opposite second direction in the optical waveguide ring resonator as a counterclockwise (CCW) SBS beam.

Example 16 includes the SBS laser system of Example 15, wherein: a portion of the CW pump beam is coupled out of the waveguide ring resonator at the second optical coupler region into the second bus waveguide along a first direction as an output CW pump beam; and a portion of the CCW SBS beam is coupled out of the waveguide ring resonator at the second optical coupler region into the second bus waveguide along a second direction as an output CCW SBS beam.

Example 17 includes a method of fabricating a photonics device, the method comprising: forming a waveguide platform on a photonics chip, the waveguide platform formed by a process comprising: forming a substrate layer over the photonics chip; depositing a cladding layer over the substrate layer; and forming a waveguide layer that is embedded in the cladding layer, the waveguide layer including a waveguide ring resonator, and a bus waveguide optically coupled with the waveguide ring resonator; wherein the waveguide ring resonator is formed to generate a stimulated Brillouin scattering (SBS) beam when a pump laser beam is optically coupled into the waveguide ring resonator; wherein the waveguide ring resonator is formed to have a radius and corresponding round-trip path length such that a free-spectral range (FSR) of the waveguide ring resonator is misaligned with respect to a SBS gain peak, such that an SBS gain coefficient has a magnitude to produce a substantially reduced linewidth of the SBS beam.

Example 18 includes the method of Example 17, wherein the substrate layer comprises silicon, the cladding layer comprises silicon dioxide, and the waveguide layer comprises silicon nitride.

Example 19 includes the method of any of Examples 17-18, wherein the linewidth of the SBS beam is about 1 Hz to about 10 mHz.

From the foregoing, it will be appreciated that, although specific embodiments have been described herein for purposes of illustration, various modifications may be made without deviating from the scope of the disclosure. Thus, the described embodiments are to be considered in all respects only as illustrative and not restrictive. In addition, all changes that come within the meaning and range of equivalency of the claims are to be embraced within their scope.

## Claims

1. A photonics device, comprising:
a waveguide platform comprising:
a substrate layer;
a cladding layer over the substrate layer; and
a waveguide layer embedded in the cladding layer, the waveguide layer including a waveguide ring resonator, and a bus waveguide in optical communication with the waveguide ring resonator;
wherein the waveguide ring resonator is configured to generate a stimulated Brillouin scattering (SBS) beam when a pump laser beam is optically coupled into the waveguide ring resonator from the bus waveguide;
wherein the waveguide ring resonator has a radius and corresponding round-trip path length such that a free-spectral range (FSR) of the waveguide ring resonator is misaligned with respect to a SBS gain peak of the SBS beam, such that an SBS gain coefficient has a magnitude to produce a substantially reduced linewidth of the SBS beam.

2. The photonics device of claim 1, wherein the linewidth of the SBS beam is about 1 Hz to about 10 mHz.

3. The photonics device of claim 1, wherein the waveguide platform is coupled to a photonics chip.

4. A stimulated Brillouin scattering (SBS) laser system, comprising:
a photonics chip;
a pump laser device on the photonics chip, the pump laser device operative to emit a pump light beam;
an optical waveguide pathway on the photonics chip, the optical waveguide pathway in optical communication with the pump laser device; and
an optical waveguide resonator on the photonics chip, the optical waveguide resonator in optical communication with the pump laser device through the optical waveguide pathway;
wherein the optical waveguide resonator is configured to receive a portion of the pump light beam such that the portion of the pump light beam travels in a first direction in the optical waveguide resonator;
wherein when an optical frequency of the portion of the pump light beam matches a resonance frequency of the optical waveguide resonator, an optical power density within the optical waveguide resonator increases such that beyond a certain threshold power, the portion of the pump light beam produces lasing of a first order Brillouin wave including a SBS wave having a SBS gain peak, wherein the SBS wave travels in an opposite second direction in the optical waveguide resonator;
wherein the optical waveguide resonator has a radius and corresponding round-trip path length such that a free-spectral range (FSR) of the optical waveguide resonator is misaligned with respect to the SBS gain peak, such that an SBS gain coefficient has a magnitude to produce a substantially reduced linewidth of the SBS wave.

5. The SBS laser system of claim 4, further comprising:
an SBS output in optical communication with the optical waveguide resonator;
wherein the SBS output is configured to receive the SBS wave from the optical waveguide resonator.

6. The SBS laser system of claim 5, wherein the optical waveguide pathway includes a first optical pathway comprising a first bus waveguide optically coupled to an output of the pump laser device.

7. The SBS laser system of claim 6, wherein the first bus waveguide is optically coupled to the waveguide ring resonator at a first optical coupler region on a first side of the waveguide ring resonator.

8. The SBS laser system of claim 7, wherein the optical waveguide pathway includes a second optical pathway comprising a second bus waveguide optically coupled to the waveguide ring resonator at a second optical coupler region on a second side of the waveguide ring resonator.

9. The SBS laser system of claim 8, wherein:
the waveguide ring resonator is configured to receive the portion of the pump light beam from the first bus waveguide at the first optical coupler region, such that the portion of the pump light beam travels in the first direction in the waveguide ring resonator as a clockwise (CW) pump beam;
the SBS wave travels in the opposite second direction in the optical waveguide ring resonator as a counterclockwise (CCW) SBS beam.
a portion of the CW pump beam is coupled out of the waveguide ring resonator at the second optical coupler region into the second bus waveguide along a first direction as an output CW pump beam; and
a portion of the CCW SBS beam is coupled out of the waveguide ring resonator at the second optical coupler region into the second bus waveguide along a second direction as an output CCW SBS beam.

10. A method of fabricating a photonics device, the method comprising:
forming a waveguide platform on a photonics chip, the waveguide platform formed by a process comprising:
forming a substrate layer over the photonics chip;
depositing a cladding layer over the substrate layer; and
forming a waveguide layer that is embedded in the cladding layer, the waveguide layer including a waveguide ring resonator, and a bus waveguide optically coupled with the waveguide ring resonator;
wherein the waveguide ring resonator is formed to generate a stimulated Brillouin scattering (SBS) beam when a pump laser beam is optically coupled into the waveguide ring resonator;
wherein the waveguide ring resonator is formed to have a radius and corresponding round-trip path length such that a free-spectral range (FSR) of the waveguide ring resonator is misaligned with respect to a SBS gain peak, such that an SBS gain coefficient has a magnitude to produce a substantially reduced linewidth of the SBS beam.
